(19) Europäisches Patentamt
European Patent Office
Office européen des brevets

(11) Publication number: **0 491 045 A1**

(12) # EUROPEAN PATENT APPLICATION published in accordance with Art. 158(3) EPC

(21) Application number: **91910011.5**

(51) Int. Cl.[5]: **C08G 61/02**, C08G 59/62

(22) Date of filing: **08.07.91**

(86) International application number:
**PCT/JP91/00908**

(87) International publication number:
**WO 92/01011 (23.01.92 92/03)**

(30) Priority: **10.07.90 JP 180675/90**
**18.07.90 JP 187883/90**
**13.08.90 JP 211546/90**
**17.08.90 JP 215838/90**
**10.09.90 JP 237182/90**
**10.09.90 JP 237183/90**

(43) Date of publication of application:
**24.06.92 Bulletin 92/26**

(84) Designated Contracting States:
**CH DE ES FR GB GR IT LI LU NL SE**

(71) Applicant: **MITSUI TOATSU CHEMICALS, Inc.**
**2-5 Kasumigaseki 3-chome**
**Chiyoda-Ku Tokyo 100(JP)**

(72) Inventor: **URAKAMI, Tatsuhiro**
**350, Arai-cho, Hodogaya-ku**
**Yokohama-shi, Kanagawa-ken 240(JP)**
Inventor: **YAMAGUCHI, Keizaburo**
**1627-92, Toke-cho**
**Chiba-shi, Chiba-ken 299-31(JP)**
Inventor: **MACHIDA, Koichi**
**262-32, Kamigo-cho, Sakae-ku**
**Yokohama-shi, Kanagawa-ken 247(JP)**
Inventor: **KITAHARA, Mikio**
**2882, Iijima-cho, Sakae-ku**
**Yokohama-shi, Kanagawa-ken 244(JP)**
Inventor: **KUBO, Takayuki**
**1612, Kosugaya-cho, Sakae-ku**
**Yokohama-shi, Kanagawa-ken 247(JP)**
Inventor: **TORIKAI, Motoyuki**
**669, Kajigaya-cho, Sakae-ku**
**Yokohama-shi, Kanagawa-ken 247(JP)**
Inventor: **ASAHINA, Koutaro**
**4-5-45, Dai, Kamakura-shi**
**Kanagawa-ken 247(JP)**
Inventor: **TANAKA, Junsuke**
**1409, Yamanouchi**
**Kamakura-shi, Kanagawa-ken 247(JP)**
Inventor: **YAMAGUCHI, Akihiro**
**1-13-24, Zaimokuza**
**Kamakura-shi, Kanagawa-ken 248(JP)**
Inventor: **IKADO, Shuhei**
**5, Takiharu-cho, Minami-ku**
**Nagoya-shi, Aichi 457(JP)**

(74) Representative: **Nicholls, Kathryn Margaret**
**Mewburn Ellis, 2 Cursitor Street**
**London EC4A 1BO(GB)**

(54) **NOVEL PHENOL/ARALKYL RESIN, PRODUCTION THEREOF, AND EPOXY RESIN COMPOSITION CONTAINING THE SAME.**

(57) A low-molecular phenol/aralkyl resin with a softening point of 100 °C or below, represented by general formula (I), wherein X represents a divalent group of formula (II) or (III), and n represents an integer of 0 to 10; a process for producing the resin; and an epoxy resin composition containing the resin as a curing agent.

EP 0 491 045 A1

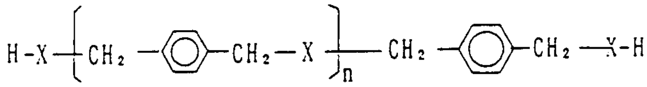 (I)

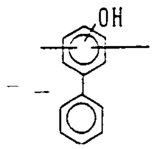 (II)

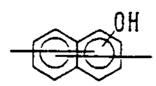 (III)

## Technical Field

The present invention relates to a novel phenolic aralkyl resin having a low molecular weight, preparation process of the resin, and an epoxy resin composition comprising the low molecular weight phenolic aralkyl resin as a curing component.

The low molecular weight phenolic aralkyl resin of the invention gives a thermosetting resin composition in combination with hexamine as other common phenol resin, and can also be utilized for a raw material and a curing agent of an epoxy resin and an additive of various resins.

Particularly in the case of using for the curing agent of the epoxy resin, the epoxy resin composition obtained is excellent in resistance to heat, impact, cracking and moisture, has outstanding workability, and can be processed by various means such as casting, adhesion, lamination and molding. The composition is particularly suitable for a sealing material of a semiconductor integrated circuit (IC).

## Background Art

Many curing agents have been conventionally applied to the epoxy resin composition in the above uses. The curing agents are, for example, diethylenetriamine, isophoronediamine, m-xylylenediamine, m-phenylenediamine, 4,4'-diaminodiphenyl sulfone and other aliphatic or aromatic amine compounds; phthalic anhydride, trimellitic anhydride, pyromellitic dianhydride, maleic anhydride and other acid anhydrides; phenolic novolak and other phenolic resins; polyamides; modified polyamines; and imidazoles.

However, epoxy resin compositions obtained by reacting these curing agents with various epoxy resins derived from 2,2'-(4-hydroxyphenyl)propane, phenolic novolak resin, o-cresol novolak resin and 4,4'-methylenedianiline have both characteristics and disadvantages in their properties and are difficult to satisfy properties required for the matrix resin.

Recently, IC tends to increase density and integration in particular. Accordingly, the matrix resin for sealing IC is required to further enhance the level of moisture resistance.

However, moisture resistance of the matrix resin generally varies in opposite to the heat resistance of the resin. Thus, moisture resistance decreases when heat resistance is intended to increase by introducing a heat-resistant functional group into a polymer molecule or raising the density of the functional groups. Consequently, no matrix resin for sealing IC has been conventionally found to satisfy both moisture resistance and heat resistance. Either moisture resistance or heat resistance must be selected at the sacrifice of the other depending upon the use conditions of the matrix resin.

Impact resistance can be improved by providing flexibility for the cured composition. Recently, flexibility is provided by the addition of polyethylene glycol or polypropylene glycol or by forming a phase of dispersed rubber particles in the resin matrix to increase energy absorption at breakage with the aid of sea-island structure. However, these methods also lead to remarkable reduction of heat resistance and problems on workability and reproducibility.

Further, a matrix resin for heat-resistant composites and a heat-resistant adhesive require long time stability at temperature for use in addition to the resistance to heat, moisture and impact, and also require low deterioration by light or oxygen in the air.

In order to improve these disadvantages of the matrix resin, the formaldehyde linkage of novolak which is conventionally a most common phenolic resin is replaced by a xylylene linkage as disclosed in Japanese Patent Publication SHO 47-15111(1972).

The phenol-aralkyl resin described in the above patent can be obtained by reacting 1 mole of aralkyl halide or an aralkyl alcohol derivative with 1.3 to 3.0 moles, preferably 1.5 to 2.5 moles of a phenol compound. The resin is prepared so as to react substantially the whole phenol compound. The resin obtained can provide cured articles by using hexamethylenetetramine or other known curing agents which are generally used for novolak. The phenol-aralkyl resin can also be used for a curing agent of epoxy resin as disclosed in Japanese Patent Publication SHO 48-10960(1973). In any cases, fillers such as silica and metal oxides and other additives such as pigments can be blended.

As an example of the resin thus obtained, a phenol-aralkyl resin derived from phenol has been marketed from Mitsui Toatsu Chemicals Inc. with a trade mark XYLOK and is used for an epoxy resin and an IC sealing agent as disclosed in Japanese Patent Publication SHO 62-28165(1987) and Japanese Laid-Open Patent SHO 59-105018(1984), respectively.

However, matrix resin used for recent composite materials requires a higher level of properties such as heat resistance, mechanical strengths, oxidation resistance and moisture resistance. As a result, the phenol-aralkyl resin derived from phenol cannot satisfy these requirements and much improvement has been desired particularly in moisture resistance.

In a matrix resin for use in composite materials, that is, the resin comprising raw material resin, curing agent and other additives, the raw material resin is required to have a low melting point. The melting point is preferably 100 °C or less, and the resin is most preferably liquid at room temperature.

The resin having a melting point in the above range can improve workability. For example, excessive heating in melt-kneading or use of solvents in blending the raw material resin and various additives can be mitigated or avoided. When the resin having a softening point exceeding 100 °C is used for a sealing material, lead wires connecting a substrate with semiconductor IC are liable to be deformed or broken due to the high viscosity of molten resin in the sealing step.

Disclosure of Invention

The object of the present invention is to improve the moisture resistance of a matrix resin for composite materials without impairing heat resistance, oxidation resistance and mechanical properties, to provide a resin having a low softening point and good workability, and further to provide a resin composition which is excellent in heat resistance, impact resistance, crack resistance, moisture resistance and workability by using thus-obtained resin as a curing agent component of an epoxy resin.

The present inventors have carried out an intensive investigation in order to accomplish the above objects. As a countermeasure for improving properties and workability, phenol compounds such as naphthol or phenylphenol which have higher molecular weights than phenol have been used as raw materials. Thus, the density of the hydroxyl group in the polymer has been reduced, as a trial to increase hydrophobic property and to improve moisture resistance. However, the resin prepared by conventionally known processes, for example, a process disclosed in Japanese Patent Publication SHO 47-15111(1972), had a softening point exceeding 100 °C and improvement of processability could not be achieved. The present inventors have further continued the investigation and completed the present invention.

That is, an aspect of the present invention is a low molecular weight phenolic aralkyl resin comprising a structure represented by the formula (I):

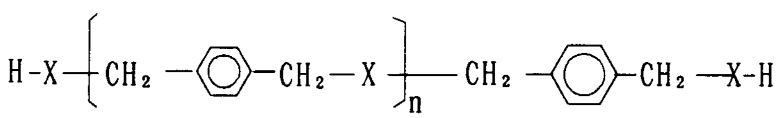

(I)

wherein X is a divalent group of

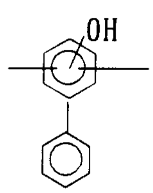

or

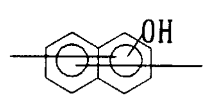

and n is an integer of 0 to 10, and having a softening point of 100 °C or less.

More specifically, the aspect is a low molecular weight phenylphenol aralkyl resin represented by the formula (II):

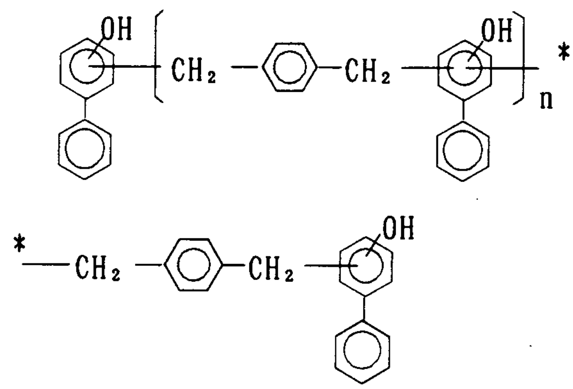

( II )

wherein n is an integer of 0 to 10, and having a softening point of 100 ° C or less; and a low molecular weight naphthol aralkyl resin represented by the formula (III):

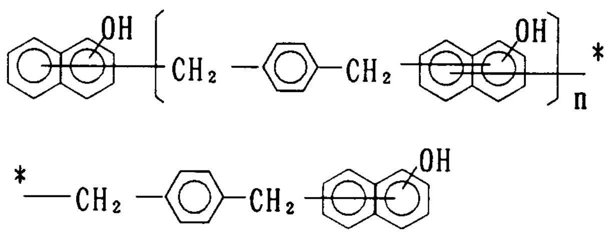

( III )

wherein n is an integer of 0 to 10, and having a softening point of 100 ° C or less.

Another aspect of the present invention is a process for preparing a low molecular weight phenolic aralkyl resin represented by the formula (I) and having a softening point of 100 ° C or less comprising reacting 1 mole of an aralkyl halide or aralkyl alcohol derivative represented by the formula (IV):

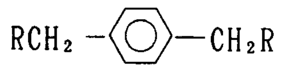

( IV )

wherein R is a halogen atom, hydroxyl group or lower alkoxy group having 1 to 4 carbon atoms, with more than 3 moles of naphthol or phenylphenol in the presence of an acid catalyst.

A further aspect of the present invention is an epoxy resin composition which is excellent in heat resistance, impact resistance, crack resistance, moisture resistance and workability, comprising the low molecular weight phenolic aralkyl resin as a curing agent in an amount of 10 to 100 % by weight in the whole curing agent component.

The low molecular weight phenolic aralkyl resin of the invention has lower hydroxyl group density per unit weight as compared with marketed XYLOK resin which is prepared from phenol and contains the same xylene linkage, and comprises rigid skeleton of naphthol or phenylphenol.

Consequently, the cured epoxy resin composition obtained by using the aralkyl resin as a curing agent is almost equivalent in heat resistance and mechanical properties and superior in moisture resistance to the cured epoxy resin composition obtained by using marketed XYLOK resin as a curing agent.

The hexamine cured composition of the low molecular weight phenolic aralkyl resins of the invention tends to have higher heat distortion temperature due to increased crosslinking density as compared with the hexamine cured composition of marketed XYLOK resin.

Further, phenolic aralkyl resins having different softening points can be obtained by changing the mole ratio of naphthol or phenylphenol to aralkyl halide or the aralkyl alcohol derivative. Thus the resin can be prepared so as to have a suitably controlled softening point range depending upon the conditions for use.

Such softening point range extends the field for use as a matrix resin of composite materials. For example, the epoxy resin composition derived from the phenolic aralkyl resin of the invention can be applied to IC sealing materials and hardened resin crosslinked by the phenolic aralkyl resin of the invention

can be applied to brake materials. Thus, possibility for selecting a suitable softening point is a useful characteristic of the phenolic aralkyl resin of the invention.

Best Mode for Carrying Out the Invention

The low molecular weight phenolic aralkyl resin of the invention is represented by the formula (I):

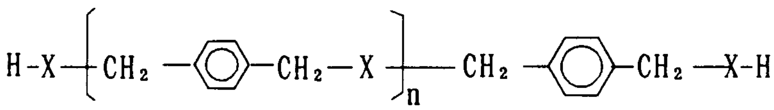

( I )

wherein X is a divalent group of

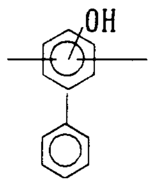

or

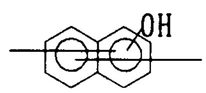

and n is an integer of 0 to 10. That is, X is a divalent group derived from naphthol or phenylphenol.

More specifically, the phenolic aralkyl resin of the invention is a low molecular weight phenylphenol aralkyl resin having a structure represented by the formula (II):

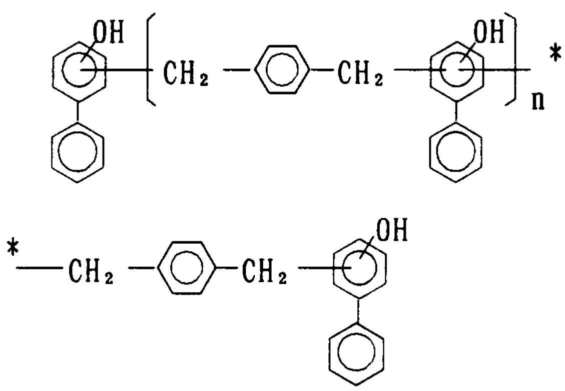

( II )

wherein n is an integer of 0 to 10, a molecular weight of 450 to 3200 and a softening point of 100 °C or less by JIS K-2548 or being a liquid state at a room temperature; and a low molecular weight naphthol aralkyl resin having a structure represented by the formula (III):

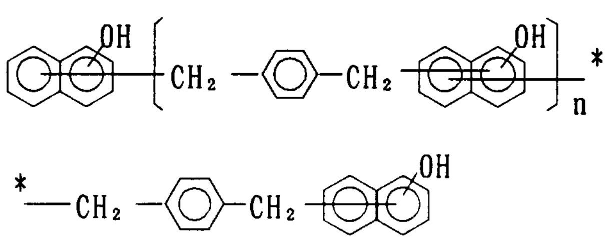

( III )

wherein n is an integer of 0 to 10, a molecular weight of 400 to 2850 and a softening point of 100 °C or less or being a liquid state at a room temperature. The low molecular weight phenolic aralkyl resin preferably contains 40 % or more of the compound having n = 0 in the above formula (I).

The process for preparing the low molecular weight phenolic aralkyl resin of the invention will be illustrated in detail hereinafter.

The low molecular weight phenolic aralkyl resin of the invention is prepared by reacting 1 mole of the aralkyl halide or aralkyl alcohol derivative represented by the above formula (IV) with more than 3 moles of the phenol compound in the presence of an acid catalyst.

The phenol compound used in the process of the invention includes, for example, naphthols such as $\alpha$ -naphthol and $\beta$ -naphthol; and phenylphenols such as o-phenylphenol, m-phenylphenol and p-phenylphenol.

Aralkyl halide or an aralkyl alcohol derivative is a compound wherein R is a halogen atom such as chlorine or bromine, a hydroxyl group or an alkoxy group in the above formula (IV). The alkoxy group is preferably a lower alkoxy group having 4 or less carbon atoms. Alkoxy groups having 5 or more carbon atoms have unfavorably slow reaction rate. In the butoxy group which has 4 carbon atoms, tert-butoxy group has somewhat slow reaction rate.

Exemplary aralkyl halides which can be favorably used in the invention include $\alpha,\alpha'$-dichloro-p-xylene, $\alpha,\alpha'$-dibromo-p-xylene and $\alpha,\alpha'$-diiodo-p-xylene. Exemplary aralkyl alcohol derivatives include $\alpha,\alpha'$-dihydroxy-p-xylene, $\alpha,\alpha'$-dimethoxy-p-xylene, $\alpha,\alpha'$-diethoxy-p-xylene, $\alpha,\alpha'$-di-n-propoxy-p-xylene, $\alpha,\alpha'$-diisopropoxy-p-xylene, $\alpha,\alpha'$-di-n-butoxy-p-xylene, $\alpha,\alpha'$-di-sec-butoxy-p-xylene and $\alpha,\alpha'$-diisobutoxy-p-xylene.

In reacting the aralkyl halide or the aralkyl alcohol derivative which is represented by the formula (IV) with naphthol or phenylphenol, from 3.0 to 20 moles, preferably from 3.0 to 10 moles of phenylphenol or naphthol are heated with 1 mole of the aralkyl halide or the aralkyl alcohol derivative in the presence of the acid catalyst.

Greater amount of phenylphenol or naphthol used tends to increase content of the compound having $n=0$ in the resulting resin. When the amount is less than 3.0 moles, the content of the compound having $n=0$ in the resulting resin is less than 40 % and the softening point of the resin unfavorably exceeds 100 °C.

The reaction temperature is preferably 110 °C or more. The temperature less than 110 °C leads to a slow reaction rate. In order to complete the reaction as quickly as possible, the reaction temperature is preferably in the range of from 130 to 250 °C, more preferably from 130 to 180 °C. The reaction time depends upon the reaction temperature and is generally from 1 to 30 hours.

The acid catalyst which can be used is inorganic and organic acids and includes, for example, mineral acids, such as hydrochloric acid, sulfuric acid and phosphoric acid; Friedel-Crafts catalysts such as zinc chloride, aluminum chloride, stannic chloride and ferric chloride; organic sulfonic acids such as methane sulfonic acid and p-toluenesulfonic acid; sulfate esters such as dimethyl sulfate and diethyl sulfate; and super strong acids such as trifluoromethanesulfonic acid and boron trifluoride. These catalysts can be used singly or in combination.

The amount of the catalyst used is from 0.0001 to 10 % by weight, preferably from 0.001 to 1 % by weight for the total weight of naphthol or phenylphenol and aralkyl halide or the aralkyl alcohol derivative.

With the progress of the reaction, generated hydrogen halide, water or alcohol is distilled out of the reaction system. After completing the reaction, unreacted naphthol or phenylphenol is removed from the reaction mixture by vacuum distillation or other suitable methods.

A resin consisting of a mixture of the phenolic aralkyl compound having the structure represented by the above formula (I) wherein n is an integer of from 0 to 10 can be obtained by the above process.

The low molecular weight phenolic aralkyl resin obtained by the above process can be applied as a curing agent to any kind of epoxy resin.

The epoxy resin composition of the invention is obtained by incorporating the low molecular weight phenolic aralkyl resin of the invention as a curing agent to the epoxy resin.

No particular restriction is imposed upon the epoxy resin used so long as the epoxy resin has two or more epoxy groups in a molecule.

Useful epoxy resins are obtained by reacting epihalohydrin with polyfunctional compounds. The polyfunctional compounds include, for example, polyhydric phenols such as resorcinol, hydroquinone, bishydroxydiphenyl ether, bishydroxybiphenyl, trihydroxyphenylmethane, tetrahydroxyphenylmethane, tetrahydroxyphenylethane, alkanetetrakisphenol, dihydroxynaphthalene and its condensation product; phenoldicyclopentadiene condensation products such as phenoldicyclopentadiene resin, o-cresol-dicyclopentadiene resin, p-cresol-dicyclopentadiene resin, m-cresol-dicyclopentadiene resin, m-phenylphenol-dicyclopentadiene resin and p-phenylphenoldicyclopentadiene resin; resol resin; polyhydric alcohols such as ethylene glycol, neopentyl glycol, glycerol, trimethylolpropane, pentaerythritol, diethylene glycol and propylene glycol; amines such as ethylenediamine, aniline and bis(4-aminophenyl)methane; and polycarboxylic acids such as adipic acid, phthalic acid and isophthalic acid.

The epoxy resins which can exhibit particularly excellent effect in the invention are obtained by reacting

epihalohydrin with 2,2-bis(4-hydroxyphenyl)propane, 2,2-bis(3,5-dibromo-4-hydroxyphenyl)propane, bis(4-hydroxyphenyl)methane, phenol-novolak resin, o-cresol-novolak resin, 4,4'-methylenedianiline, phenolic-aralkyl resin represented by the formula (V):

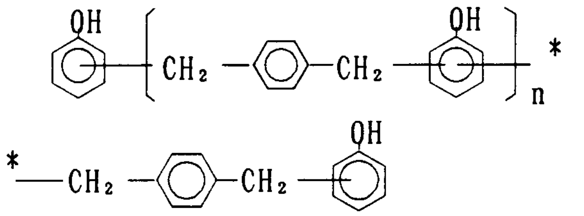

(V)

wherein n is an integer of from 0 to 100, or resorcinol-aralkyl resin represented by the formula (VI):

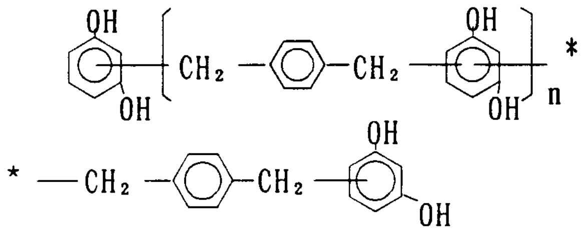

(VI)

wherein n is an integer of from 0 to 100.

The above phenolic aralkyl resin can be used as a curing agent in combination with other known curing agents in the resin composition of the invention.

In order to obtain an epoxy resin composition which exhibits high level of properties in resistance to heat, impact, crack and moisture, it is required to contain the phenolic aralkyl resin of the invention in an amount of 10 % by weight or more, preferably from 30 to 100 % by weight for the total weight of the curing agent. No particular limitation is imposed upon the proportion of the phenolic aralkyl resin to the epoxy resin. The curing agent is used so that active hydrogen of the curing agent is generally from 0.5 to 1.5 equivalent, preferably from 0.8 to 1.2 equivalent per equivalent of epoxy group in the epoxy resin.

In the preparation of various curing agents by using the phenolic aralkyl resin of the invention, inorganic fillers and various additives can be added, if desired. The characteristics of the novel phenolic aralkyl resin of the invention as a curing agent can also be exhibited in the presence of these various additives and a resin composition having excellent properties can be obtained.

Useful inorganic fillers include powder such as silica, alumina, silicon nitride, silicon carbide, talc, calcium silicate, mica, clay and titanium white; and fiber such as glass fiber and carbon fiber. Preferred fillers are crystalline silica and/or molten silica in view of thermal expansion coefficient and thermal conductivity. Spherical fillers or a mixture of spherical and amorphous fillers are preferable in view of flowability in processing the resin composition.

The amount of inorganic fillers are generally from 100 to 900 parts by weight, preferably from 200 to 600 parts by weight for 100 parts by weight of the sum of the epoxy resin and the curing agent.

The above inorganic fillers are preferably used in combination with coupling agents in order to improve adhesion to the resin and to enhance mechanical strength and thermal resistance. Coupling agents which can be used are silane-base titanate-base, aluminate-base and zirco-aluminate-base coupling agents. Silane-base coupling agents are preferably used. Silane-base coupling agents having functional groups which react with epoxy resin are particularly preferred.

Exemplary silicone-base coupling agents which can react with the epoxy resin include vinyltrimethoxysilane, vinyl-triethoxysilane, N-(2-aminoethyl)-3-aminopropyltrimethoxysilane, 3-aminopropyltriethoxysilane, 3-anilinopropyltrimethoxysilane, 3-glycidoxypropyltrimethoxysilane, 3-glycidoxypropylmethyldimethoxysilane, 2-(3,4-epoxycyclohexyl)-ethyltrimethoxysilane, 3-methacryloxypropyltrimethoxysilane, and 3-mercaptopropyltrimethoxysilane.

These silane-base coupling agents are used singly or in combination and preferably adsorbed or fixed by reaction on the surface of the inorganic fillers in advance.

Curing accelerators are preferably used in curing the resin composition of the invention. Representative

accelerators include, for example, imidazoles such as 2-methylimidazole, 2-methyl-4-ethylimidazole and 2-heptadecylimidazole; amines such as triethanolamine, triethylenediamine and N-ethylmorpholine; organic phosphins such as tributylphosphine, triphenylphosphine and tritolylphosphine; tetraphenyl borates such as tetraphenylphosphonium tetraphenylborate and triethylammonium tetraphenylborate; and 1,8-diazo-bicyclo (5,4,0) undecene-7 and its derivative.

The above curing accelerators can be used singly or as a mixture. These accelerates are used in the range of from 0.01 to 10 parts by weight for 100 parts by weight of the sum of the epoxy resin and the curing agent.

The above resin composition can be blended, if desired, with release agents such as fatty acids, fatty acid salts and waxes; colorants such as carbon black and various types of silicone oils, and kneaded to prepare molding materials.

The present invention will hereinafter be illustrated in detail by way of examples and application examples. However, these examples and application examples are not intended to limit the scope of the present invention.

Example 1

To a reaction vessel equipped with a stirrer, thermometer, azeotropic water separation trap and a reflux condenser, 249 g (1.5 moles) of $\alpha,\alpha'$-dimethoxy-p-xylene and 1080 g (7.5 moles) of $\alpha$-naphthol and 0.67 g (0.05 %) of methanesulfonic acid were charged. The mixture was reacted at 150 ~ 160 °C for 4 hours with stirring. Generated methanol was successively trapped and removed from the reaction system. After completing the reaction, unreacted naphthol was removed by distillation under reduced pressure to obtain 470 g of $\alpha$-naphthol aralkyl resin having the formula (I). The composition (Area %) of the resin by high performance liquid chromatography was 61.5 % in $n = 0$ [the compound having $n = 0$ in the formula (I)] , 18.2 % in $n = 1$, 8.2 % in $n = 2$ and 11.6 % in $n \geqq 3$. The resin had a hydroxy equivalent of 207.2 g/eq. and a softening point of 72 °C.

Example 2

To a reaction vessel equipped with a stirrer, thermometer, azeotropic water separation trap and a reflux condenser, 207.3 g (1.5 moles) of $\alpha,\alpha'$-dihydroxy-p-xylene and 2160 g (15 moles) of $\beta$-naphthol and 1.18 g (0.05 %) of methanesulfonic acid. The mixture was reacted at 150 ~ 160 °C for 4 hours with stirring. Generated water was successively trapped and removed from the reaction system. After completing the reaction, unreacted naphthol was removed by distillation under reduced pressure to obtain 438 g of $\beta$-naphthol aralkyl resin having the formula (I). The composition (Area %) of the resin by high performance liquid chromatography was 83.4 % in $n = 0$ [the compound having $n = 0$ in the formula (I)] , 9.2 % in $n = 1$, 4.6 % in $n = 2$ and 2.8 % in $n \geqq 3$. The resin had a hydroxy equivalent of 202.6 g/eq and a softening point of 42 °C.

Example 3

To a reaction vessel equipped with a stirrer, thermometer, azeotropic water separation trap and a reflux condenser, 249 g (1.5 moles) $\alpha,\alpha'$-dimethoxy-p-xylene and 1275 g (7.5 moles) of o-phenylphenol and 7.62 g (0.5 %) of methanesulfonic acid were charged. The mixture was reacted at 150 ~ 160 °C for 4 hours with stirring. Generated methanol was successively trapped and removed from the reaction system. After completing the reaction, unreacted o-phenylphenol was removed by distillation under reduced pressure to obtain 482 g of o-phenylphenol aralkyl resin having the formula (I). The composition (Area %) of the resin by high performance liquid chromatography was 61.8 % in $n = 0$ [the compound having $n = 0$ in the formula (I)] , 17.9 % in $n = 1$, 8.5 % in $n = 2$ and 11.8 % in $n \geqq 3$. The resin had a hydroxy equivalent of 253.2 g/eq and a softening point of 64 °C.

Example 4

To a reaction vessel equipped with a stirrer, thermometer, azeotropic water separation trap and a reflux condenser, 207.3 g (1.5 moles) of $\alpha,\alpha'$-dihydroxy-p-xylene and 2550 g (15 moles) of p-phenylphenol and 1.38 g (0.05 %) of methanesulfonic acid were charged. The mixture was reacted at 150 ~ 160 °C for 4 hours with stirring. Generated water was successively trapped and removed from the reaction system. After completing the reaction, unreacted p-phenylphenol was removed by distillation under reduced pressure to

obtain 453 g of p-phenylphenol aralkyl resin having the formula (I). The composition (Area %) of the resin by high performance liquid chromatography was 83.6 % in n = 0 [the compound having n = 0 in the formula (I)] , 9.4 % in n = 1, 4.1 % in n = 2 and 2.9 % in n ≧ 3. The resin had a hydroxy equivalent of 248.6 g/eq and a softening point of 42 °C.

Application Examples 1-4

The resins obtained in Examples 1-4 were used as curing agents of epoxy resin. Bis-(4-hydroxyphenyl)-methane (Bisphenol-F) type epoxy resin, EPIKOTE 807 (trade mark of Yuka Shell Epoxy Co.) was blended with the curing agents under conditions illustrated in Table 1. The mixture was poured into a mold and cured at 140 °C. Properties of the product were tested and results are illustrated in Table 1.

Properties illustrated in Table 1,2 and 3 were measured by the following methods.

Heat Distortion Temperature (HDT): JIS K-7207

Glass Transition Temperature (Tg): TMA Method.

Measured with Shimadzu TMA-System DT-30

Flexural Strength, Elastic Modulus and Elongation: JIS K-7113

Boiling Water Absorption (D-2/100): Weight increase after immersing in boiling water for 2 hours at 100 °C was measured.

Water Absorption (%): Weight increase after standing in a thermohydrostat at 65 °C, 95 % RH for 168 hours was measured.

Comparative Example 1

The same procedures as described in Application Examples 1-4 were carried out except that the resins obtained in Example 1-4 were replaced by phenol-novolak resin, BRG 558 (Trade mark of Showa Kobunshi Co.).

Results are illustrated in Table 1.

Application Examples 5-16 and 17-28

The naphthol aralkyl resins obtained in Examples 1 and 2 were used as curing agents singly or in combination with other curing agents. These aralkyl resins were blended with various kinds of epoxy resin as illustrated in Table 2 and further 1 part by weight of 2-undecylimidazole was added as a curing accelerator.

The mixture was melt-kneaded at 120 °C and cured at 145 °C for 2 hours and 170 °C for 2.5 hours. Physical properties were measured on the cured product thus obtained. Result are illustrated in Table 2.

The phenylphenol aralkyl resins obtained in Examples 3 and 4 were used as curing agents. The same procedures as above were carried out to obtain cured products. Properties of the cured product were measured and results are illustrated in Table 3.

In Tables 2 and 3, following epoxy resins were used.

(A) Epoxy resin derived from 2,2-bis(4-hydroxyphenyl)propane having an epoxy equivalent of 189, EPIKOTE 828 (Trade mark of yuka Shell-Chemical Co.)

(B) Epoxy resin derived from phenol-novolak resin having an epoxy equivalent of 179, DEN-431(Trade mark of Dow Chemical Co.)

(C) Epoxy resin derived from o-cresol novolak resin, having an epoxy equivalent of 218, EOCN-102 S-(Trade mark of Nippon Kayaku Co.)

(D) Epoxy resin derived from 4,4'-methylene dianiline having an epoxy equivalent of 122, ARALDITE MY-720 (Trade Mark of Ciba-Geigy Co.)

(E) Epoxylated phenol-aralkyl resin prepared by the following process.

To a reaction vessel equipped with a stirrer, thermometer, azeotropic water separation trap and a reflux condenser, 250 g (1.5 moles) of α,α'-dimethoxy-p-xylene and 847 g (9 moles) of phenol and 1.1 g of p-toluenesulfonic acid were charged. The mixture was reacted at 130 ~ 150 °C for 3 hours with stirring. Generated methanol was successively trapped and removed from the reaction system. After completing the reaction, unreacted phenol was removed by distillation under reduced pressure to obtain 393 g of phenol aralkyl resin. The composition (Area %) of the resin by high performance liquid chromatography was 60.3 % in n = 0, 24.3 % in n = 1, 9.2 % in n = 2 and 6.2 % in n ≧ 3.

To a reaction vessel equipped with a stirrer, azeotropic separating trap, and dropping funnel, 393 g of the resin thus obtained and 1100 g (11.9 moles) of epihalohydrin were charged. The mixture was heated to

115 to 119 °C and 275 g of a 40 % aqueous sodium hydroxide solution was added dropwise over 4 hours while maintaining the mixture at the same temperature.

Azeotropically distilled epihalohydrin was continuously returned to the reaction vessel and separated water was removed from the system. After finishing the dropwise addition, the reaction was terminated when water separation was ceased.

Thereafter, excess epihalohydrin was removed by distillation under reduced pressure. The reaction product was dissolved in 1500 g of methyl isobutyl ketone (MIBK) and a small excess of sodium hydroxide and by-product sodium chloride were filtered off.

The product was washed twice with 300 g of water, and MIBK was removed by distillation under reduced pressure to obtain 465 g of epoxy resin as a yellow oil having an epoxy equivalent of 227 g/eq. (F) Epoxylated resorcinol-aralkyl resin prepared by the following process.

To a reaction vessel equipped with a stirrer, thermometer, azeotropic water separation trap and a reflux condenser, 150 g (1.5 moles) of α,α'-dimethoxy-p-xylene and 1650 g (15 moles) of resorcinol and 0.2 g of methanesulfonic acid were charged. The mixture was reacted at 130 ~ 150 °C for 3 hours with stirring. Generated methanol was successively trapped and removed from the reaction system. After completing the reaction, unreacted resorcinol was removed by distillation under reduced pressure to obtain 452 g of resorcinol aralkyl resin.

The composition (Area %) of the resin by high performance liquid chromatography was 60.3 % in $n=0$, 24.3 % in $n=1$, 9.2 % in $n=2$ and 6.0 % in $n \geqq 3$.

To a reaction vessel equipped with a stirrer, azeotropic separating trap, and dropping funnel, 452 g of the resin thus obtained and 1100 g (11.9 moles) of epihalohydrin were charged. The mixture was heated to 115 to 119 °C and 275 g of a 40 % aqueous sodium hydroxide solution was added dropwise over 4 hours while maintaining the mixture at the same temperature.

Azeotropically distilled epihalohydrin was continuously returned to the reaction vessel and separated water was removed from the system. After finishing the dropwise addition, the reaction was terminated when water separation was ceased.

Thereafter, excess epihalohydrin was removed by distillation under reduced pressure. The reaction product was dissolved in 1500 g of ethyl acetate, and a small excess of sodium hydroxide and by-product sodium chloride were filtered off.

The product was washed twice with 300 g of water, and ethyl acetate was removed by distillation under reduced pressure to obtain 546 g of epoxy resin as yellow oil having an epoxy equivalent of 159 g/eq.

Comparative Examples 2-4

The same procedures as described in Application Example 17 were carried out by using the epoxy resin (A), (C) or (F), and phenol novolak resin or 4,4'-diaminodiphenyl sulfone (DDS) as a curing agent.

Physical properties of the resulting products were measured. Results are illustrated in Table 3.

Application Examples 29-40

The resins obtained in Examples 1 and 2 were used singly or in combination with phenol novolak resin as curing agents for o-cresol novolak type epoxy resin, EOCN-1020 (Trade mark of Nippon Kayaku Co.). Inorganic fillers and other additives were formulated as illustrated in Table 4.

The mixture obtained was cast into a mold and cured. Properties of the cast product were measured. Results are illustrated in Table 4.

The same procedures as above were carried out by using the resins obtained in Examples 3 and 4 to obtain cured products as illustrated in Table 5. Physical properties of these products were measured. Results are illustrated in Table 5.

Test pieces for measuring physical properties illustrated in Table 4 and 5 were prepared by transfer molding the resin composition at 180 °C for 3 minutes under pressure of 30 $kg/cm^2$.

Semiconductor testing devices were prepared by mounting a test element having dimensions 10 × 10 mm on the element fixing portion of a lead frame for use in a flat package type semiconductor device and successively carrying out transfer molding at 180 °C for 3 minutes under pressure of 30 $kg/cm^2$.

These test pieces were post cured at 180 °C for 6 hours prior to carrying out the test.

Comparative Examples 5-6

The same procedures as described in Examples 29-40 were carried out except that phenol novolak

resin was used singly as the curing agent. Properties of the cured product were measured. Results are illustrated in Table 4 and Table 5.

Properties were tested by the following method.

Glass Transition Temperature: TMA method

Measured with Shimadzu TMA-System DT-30

Flexural Strength and Elastic Modulus: JIS K-6911

Tensile Strength, Elastic Modulus and Elongation: JIS K-7113

Water Absorption (%): Weight increase after standing in a thermo-hydrostat at 65 °C, 95 % RH for 168 hours was measured.

V.S.P. Test: Semiconductor testing devices were allowed to stand in a thermohydrostat at 65 °C, 95 % RH for 168 hours, and immediately immersed into FLUORINERT Liquid FC-70 (Trade Mark of Sumitomo 3M Co.). The number of semiconductor devices which generated cracks in the package resin were counted. The results are expressed in the form of a fraction. The numerator indicates the number of devices which generated cracks. The denominator indicates the total number of devices used for the test.

Application Example 41

The resin obtained in Example 1 was melt-kneaded with hexamethylenetetramine under the conditions illustrated in Table 6. The cured product obtained was subject to differential thermal analysis and thermogravimetric analysis.

Result are illustrated in Table 6.

Comparative Example 7

The same procedures as described in Application Example 41 were carried out except that a phenol novolak resin, BRG-558 (Trade mark of Showa Kobunshi Co.) was used. The cured product obtained was subjected to differential thermal analysis and thermogravimetric analysis. Results are illustrated in Table 6.

## Industrial Applicability

The epoxy resin compositions obtained by using the naphthol aralkyl resin of the present invention as a curing component have good properties such as heat resistance, impact resistance, crack resistance and moisture resistance, and are thus very valuable as various matrix resins.

Hence the aralkyl resin of the invention makes a large contribution to the field of semiconductor sealing materials where use has been conventionally restricted because of advantages and drawbacks.

Table 1

| | Application example | | | | Comparative Ex. 1 |
|---|---|---|---|---|---|
| | 1 | 2 | 3 | 4 | |
| **Formulation** | | | | | |
| Epoxy resin | Epikote 807 | ← | ← | ← | ← |
| EEW (g/eq)[1] | 160～170 | ← | ← | ← | ← |
| Amount (g) | 100 | ← | ← | ← | ← |
| Curing agent | Ex. 1 | Ex. 2 | Ex. 3 | Ex. 4 | BRG #558 |
| HEW (g/eq)[2] | 207.2 | 202.6 | 253.2 | 248.6 | 101.9 |
| Amount (g) | 126 | 123 | 149 | 146 | 62 |
| **Curing Condition** (℃/hr) | 140/1 + 175/5 | ← | ← | ← | ← |
| **Property** | | | | | |
| HDT (℃)[3] | 142 | 138 | 147 | 149 | 106 |
| Tg (℃)[4] | 164 | 160 | 166 | 168 | 121 |
| Flexural strength (kg/mm²) | 15.0 | 15.1 | 15.8 | 15.3 | 14.6 |
| Flexural modulus (kg/mm²) | 328 | 332 | 342 | 335 | 324 |
| Tensile strength (kg/mm²) | 9.21 | 9.16 | 9.45 | 9.32 | 8.56 |
| Tensile modulus (kg/mm²) | 338 | 335 | 352 | 346 | 331 |
| Elongation (%) | 1.9 | 1.7 | 2.1 | 1.8 | 2.2 |
| Boiling water absorption (D-2/100)(%)[5] | 0.30 | 0.30 | 0.30 | 0.30 | - |

Note : 1) Epoxy equivalent
2) Hydroxyl equivalent
3) Heat distortion temperature
4) Glass transition temperature
5) Boiling at 100 ℃ for 2 hours

Table 2

| Application example | 5 | 6 | 7 | 8 | 9 | 10 |
|---|---|---|---|---|---|---|
| Formulation | | | | | | |
| Epoxy resin | | | | | | |
| A | 100 | — | — | — | — | — |
| B | — | 100 | — | — | — | — |
| C | — | — | 100 | — | — | — |
| D | — | — | — | 100 | — | — |
| E | — | — | — | — | 100 | — |
| F | — | — | — | — | — | 100 |
| Curing agent | | | | | | |
| Example 1 | 133 | 133 | 115 | — | — | — |
| Example 2 | — | — | — | 220 | 119 | 169 |
| BRG #558 | — | — | — | — | — | — |
| DDS | — | — | — | — | — | — |
| Curing condition (℃/hr) | 145/2 + 170/2.5 | | | | | |
| Property | | | | | | |
| Flexural strength ($kg/mm^2$) | 12.5 | 11.8 | 13.5 | 9.8 | 10.2 | 10.8 |
| Flexural modulus ($kg/mm^2$) | 338 | 340 | 351 | 328 | 332 | 340 |
| Tensile strength ($kg/mm^2$) | 11.0 | 10.6 | 11.3 | 9.4 | 10.2 | 10.4 |
| Elongation (%) | 4.0 | 4.2 | 3.9 | 3.5 | 3.8 | 3.9 |
| Tg (℃) | 156 | 164 | 173 | 192 | 168 | 190 |
| Water absorption D-2/100 (%) | 0.31 | 0.29 | 0.29 | 0.34 | 0.32 | 0.35 |

Table 2 (Continued)

| Application example | 11 | 12 | 13 | 14 | 15 | 16 |
|---|---|---|---|---|---|---|
| **Formulation** | | | | | | |
| Epoxy resin | | | | | | |
| A | 100 | 100 | — | — | — | — |
| B | — | — | — | — | — | — |
| C | — | — | 100 | 100 | — | — |
| D | — | — | — | — | — | — |
| E | — | — | — | — | — | — |
| F | — | — | — | — | 100 | 100 |
| Curing agent | | | | | | |
| Example 1 | 66 | 40 | 58 | 23 | — | — |
| Example 2 | — | — | — | — | 85 | 47 |
| BRG #558 | 28 | 39 | — | — | 33 | 48 |
| DDS | — | — | 14 | 23 | — | — |
| **Curing condition** (℃/hr) | 145/2 + 170/2.5 | | | | | |
| Property | | | | | | |
| Flexural strength ($kg/mm^2$) | 12.6 | 12.7 | 12.8 | 12.1 | 10.8 | 12.8 |
| Flexural modulus ($kg/mm^2$) | 342 | 342 | 349 | 351 | 345 | 347 |
| Tensile strength ($kg/mm^2$) | 11.0 | 11.1 | 10.9 | 10.6 | 10.5 | 10.3 |
| Elongation (%) | 4.1 | 4.0 | 3.9 | 3.4 | 4.2 | 4.5 |
| Tg (℃) | 151 | 147 | 185 | 183 | 197 | 206 |
| Water absorption D-2/100 (%) | 0.33 | 0.34 | 0.32 | 0.36 | 0.36 | 0.38 |

Table 3

| Application example | 17 | 18 | 19 | 20 | 21 | 22 |
|---|---|---|---|---|---|---|
| Formulation | | | | | | |
| Epoxy resin | | | | | | |
| A | 100 | — | — | — | — | — |
| B | — | 100 | — | — | — | — |
| C | — | — | 100 | — | — | — |
| D | — | — | — | 100 | — | — |
| E | — | — | — | — | 100 | — |
| F | — | — | — | — | — | 100 |
| Curing agent | | | | | | |
| Example 1 | 150 | 150 | 130 | — | — | — |
| Example 2 | — | — | — | 244 | 132 | 188 |
| BRG #558 | — | — | — | — | — | — |
| DDS | — | — | — | — | — | — |
| Curing condition (℃/hr) | 145/2 + 170/2.5 | | | | | |
| Property | | | | | | |
| Flexural strength (kg/mm²) | 12.7 | 11.9 | 13.4 | 10.2 | 10.4 | 10.9 |
| Flexural modulus (kg/mm²) | 339 | 340 | 350 | 330 | 330 | 343 |
| Tensile strength (kg/mm²) | 10.8 | 10.2 | 11.0 | 9.8 | 10.2 | 10.2 |
| Elongation (%) | 4.2 | 4.3 | 4.0 | 3.7 | 3.9 | 3.9 |
| Tg (℃) | 159 | 164 | 169 | 197 | 174 | 193 |
| Water absorption D-2/100 (%) | 0.31 | 0.29 | 0.31 | 0.37 | 0.33 | 0.38 |

Table 3 (Continued)

| Application example | 23 | 24 | 25 | 26 | 27 |
|---|---|---|---|---|---|
| **Formulation** | | | | | |
| Epoxy resin | | | | | |
| A | 100 | 100 | – | – | – |
| B | – | – | – | – | – |
| C | – | – | 100 | 100 | – |
| D | – | – | – | – | – |
| E | – | – | – | – | – |
| F | – | – | – | – | 100 |
| Curing agent | | | | | |
| Example 1 | 74 | 45 | 65 | 26 | – |
| Example 2 | – | – | – | – | 94 |
| BRG #558 | 28 | 39 | – | – | 33 |
| DDS | – | – | 14 | 23 | – |
| **Curing condition** (°C/hr) | 145/2 + 170/2.5 | | | | |
| Property | | | | | |
| Flexural strength ($kg/mm^2$) | 12.8 | 12.6 | 12.8 | 12.1 | 11.2 |
| Flexural modulus ($kg/mm^2$) | 340 | 343 | 346 | 351 | 341 |
| Tensile strength ($kg/mm^2$) | 10.6 | 10.4 | 9.9 | 10.8 | 10.5 |
| Elongation (%) | 4.0 | 4.2 | 4.0 | 3.8 | 4.6 |
| Tg (°C) | 148 | 141 | 176 | 180 | 197 |
| Water absorption D-2/100 (%) | 0.32 | 0.32 | 0.32 | 0.35 | 0.36 |

Table 3 (Continued)

| Application example | 28 | Comp. Ex. 2 | Comp. Ex. 3 | Comp. Ex. 4 |
|---|---|---|---|---|
| **Formulation** | | | | |
| Epoxy resin | | | | |
| A | — | 100 | — | — |
| B | — | — | — | — |
| C | — | — | 100 | — |
| D | — | — | — | — |
| E | — | — | — | — |
| F | 100 | — | — | 100 |
| Curing agent | | | | |
| Example 1 | — | — | — | — |
| Example 2 | 52 | | | |
| BRG #558 | 48 | 56 | — | 65 |
| DDS | — | — | 28 | — |
| **Curing condition** (℃/hr) | 145/2 + 170/2.5 | | | |
| Property | | | | |
| Flexural strength ($kg/mm^2$) | 11.8 | 12.9 | 9.8 | 13.4 |
| Flexural modulus ($kg/mm^2$) | 335 | 346 | 355 | 352 |
| Tensile strength ($kg/mm^2$) | 10.1 | 10.1 | 8.6 | 10.3 |
| Elongation (%) | 4.8 | 4.1 | 2.0 | 4.8 |
| Tg (℃) | 209 | 142 | 388 | 209 |
| Water absorption D-2/100 (%) | 0.40 | 0.47 | 0.69 | 0.72 |

Note on Tables 2 and 3

Epoxy resin (A) : Epikote 828 (Trade Mark of Uka Shell Co.)
Epoxy equivalent 189

" (B) : DEN-431 (Trade Mark of Dow Chem. Co.)
Epoxy equivalent 179

" (C) : EOCN-102S (Trade Mark of Nippon Kayaku Co.)
Epoxy equivalent 218

" (D) : Araldite MY-720 (Trade Mark of Ciba-Geigy Ltd.)
Epoxy equivalent 122

" (E) : Epoxylated phenol aralkyl resin (prepared)
Epoxy equivalent 227

" (F) : Epoxylated resorcinol aralkyl resin (prepared)
Epoxy equivalent 159

BRG #558 : Phenolic novolak resin (Product of showa Kobunshi Co.)
Epoxy equivalent 104

DDS : 4,4'-Diaminodiphenyl sulfone

In all application examples, 1 part of 2-undecylimidazol ($C^{11}$ Z) was used as a curing agent.

Table 4

| | Application example 29 | 30 | 31 | 32 | 33 | 34 | Comparative Ex. 5 |
|---|---|---|---|---|---|---|---|
| Epoxy resin | 12.3 | 13.5 | 14.6 | 12.4 | 13.7 | 14.6 | 16.2 |
| Example 1 | 12.7 | 8.6 | 5.2 | - | - | - | - |
| Example 2 | - | - | - | 12.7 | 8.6 | 5.2 | - |
| Novolak type phenolic resin | - | 3.9 | 5.2 | - | 3.8 | 5.2 | 8.8 |
| Inorganic filler | 75 | 75 | 75 | 75 | 75 | 75 | 75 |
| Silane coupling agent | 0.6 | 0.6 | 0.6 | 0.6 | 0.6 | 0.6 | 0.6 |
| Triphenylphosphine | 0.1 | 0.1 | 0.1 | 0.1 | 0.1 | 0.1 | 0.1 |
| Triethylammonium tetraphenylborate | 0.3 | 0.3 | 0.3 | 0.3 | 0.3 | 0.3 | 0.3 |
| Carnauba wax | 0.45 | 0.45 | 0.45 | 0.45 | 0.45 | 0.45 | 0.45 |
| Carbon black | 0.3 | 0.3 | 0.3 | 0.3 | 0.3 | 0.3 | 0.3 |
| Antimony oxide | 1.0 | 1.0 | 1.0 | 1.0 | 1.0 | 1.0 | 1.0 |
| Glass transition temperature (℃) | 160 | 160 | 160 | 160 | 160 | 160 | 160 |
| Flexural strength ($kg/mm^2$) | | | | | | | |
| Room temperature | 15.0 | 15.0 | 15.0 | 15.0 | 15.0 | 15.0 | 15.0 |
| 215 ℃ | 1.5 | 1.5 | 1.5 | 1.5 | 1.5 | 1.5 | 1.5 |
| Flexural modulus ($kg/mm^2$) | 1350 | 1350 | 1350 | 1350 | 1350 | 1350 | 1350 |
| Water absorption (%) | 0.22 | 0.23 | 0.25 | 0.22 | 0.23 | 0.25 | 0.35 |
| V.P.S. test (Cracking test) | 2/20 | 2/20 | 5/20 | 2/20 | 2/20 | 5/20 | 18/20 |

Table 5

| | Application example | | | | | | Comparative Ex. 6 |
|---|---|---|---|---|---|---|---|
| | 35 | 36 | 37 | 38 | 39 | 40 | |
| Epoxy resin | 10.3 | 12.5 | 14.0 | 10.0 | 12.3 | 14.0 | 16.2 |
| Example 3 | 14.7 | 9.4 | 5.5 | - | - | - | - |
| Example 4 | - | - | - | 15.0 | 9.5 | 5.5 | - |
| Novolak type phenolic resin | - | 3.1 | 5.5 | - | 3.2 | 5.5 | 8.8 |
| Inorganic filler | 75 | 75 | 75 | 75 | 75 | 75 | 75 |
| Silane coupling agent | 0.6 | 0.6 | 0.6 | 0.6 | 0.6 | 0.6 | 0.6 |
| Triphenylphosphine | 0.1 | 0.1 | 0.1 | 0.1 | 0.1 | 0.1 | 0.1 |
| Triethylammonium tetraphenylborate | 0.3 | 0.3 | 0.3 | 0.3 | 0.3 | 0.3 | 0.3 |
| Carnauba wax | 0.45 | 0.45 | 0.45 | 0.45 | 0.45 | 0.45 | 0.45 |
| Carbon black | 0.3 | 0.3 | 0.3 | 0.3 | 0.3 | 0.3 | 0.3 |
| Antimony oxide | 1.0 | 1.0 | 1.0 | 1.0 | 1.0 | 1.0 | 1.0 |
| Glass transition temperature (℃) | 160 | 160 | 160 | 160 | 160 | 160 | 160 |
| Flexural strength ($kg/mm^2$) | | | | | | | |
| Room temperature | 15.0 | 15.0 | 15.0 | 15.0 | 15.0 | 15.0 | 15.0 |
| 215 ℃ | 1.5 | 1.5 | 1.5 | 1.5 | 1.5 | 1.5 | 1.5 |
| Flexural modulus ($kg/mm^2$) | 1350 | 1350 | 1350 | 1350 | 1350 | 1350 | 1350 |
| Water absorption (%) | 0.22 | 0.23 | 0.25 | 0.22 | 0.23 | 0.25 | 0.35 |
| V.P.S. test (Cracking test) | 2/20 | 2/20 | 5/20 | 2/20 | 2/20 | 5/20 | 18/20 |

Note on Tables 4 and 5

Epoxy resin : o-Cresol novolak type epoxy resin, EOCN-102S(Trade Mark of Nippon Kayaku Co.)

Novolak type phenolic resin : PN-80 (trade Mark of Nippon Kayaku Co.)

Inorganic filler : A 50/50 by weight mixture of spherical molten silica, Harimic S-CO(Trade Mark of Micron Co.) and amorphous molten silica, Fuserex RD-8(Trade Mark of Tatsumori Co.)

Silane coupling agent : SZ-6083(Trade Mark of Toray Dow-Corning Silicone Co.)

Table 6

| | Application example 41 | Comparative example 7 |
|---|---|---|
| Resin<br>HEW (g/eq)<br>Amount (g) | Example 1<br>207.2<br>100 | BRG #558<br>101.9<br>← |
| Curing agent<br>Amount (g) | hexamethylene-tetramine<br>14 | ←<br>12 |
| Curing Condition (℃/hr) | 150/0.5+ 180/0.5 | ← |
| Thermogravimetry[1)]<br>5% weight loss (℃)<br>10% weight loss (℃) | <br>397<br>443 | <br>372<br>395 |

Note : 1) Air flow rate : 100 mℓ/min
Temperature rise rate : 5 ℃/min

## Claims

**1.** A low molecular weight phenolic aralkyl resin comprising a structure represented by the formula (I) :

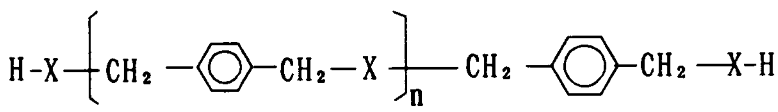

(I)

wherein X is a divalent group of

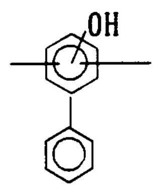

or

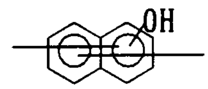

and n is an integer of from 0 to 10, and having a softening point of 100 ° C or less.

2. The low molecular weight phenolic aralkyl resin of claim 1 wherein the phenolic aralkyl resin is a low molecular weight phenylphenol aralkyl resin having a structure represented by the formula (II) :

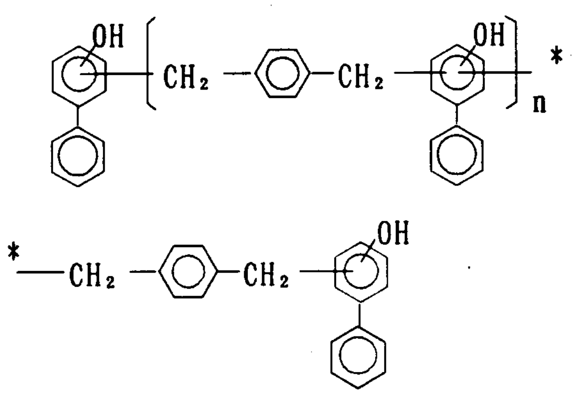

(II)

wherein n is an integer of from 0 to 10, and having a softening point of 100 ° C or less.

3. The low molecular weight phenolic aralkyl resin of claim 1 wherein the phenolic aralkyl resin is a low molecular weight naphthol aralkyl resin having a structure represented by the formula (III):

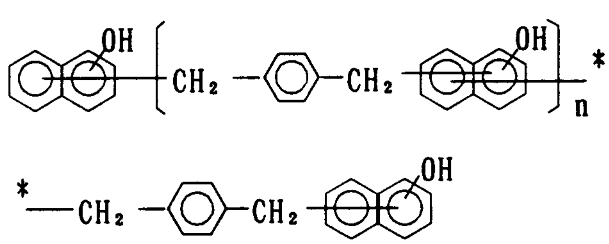

(III)

wherein n is an integer of from 0 to 10, and having a softening point of 100 ° C or less.

4. The low molecular weight phenolic aralkyl resin of claim 1, claim 2 or claim 3 wherein the phenolic aralkyl resin comprises 40 % or more of the compound having n = 0.

5. A process for preparing the low molecular weight phenolic aralkyl resin of claim 1 comprising reacting 1 mole of an aralkyl halide or an aralkyl alcohol derivative represented by the formula (IV) :

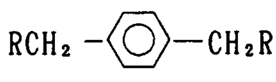

(IV)

wherein R is a halogen atom, hydroxyl group or a lower alkoxy group having from 1 to 4 carbon atoms, with more than 3 moles of phenylphenol or naphthol in the presence of an acid catalyst.

**6.** A process for preparing the low molecular weight phenolic aralkyl resin of claim 5 wherein phenylphenol is o-phenylphenol, m-phenylphenol or p-phenylphenol.

**7.** A process for preparing the low molecular weight phenolic aralkyl resin of claim 5 wherein naphthol is $\alpha$-naphthol or $\beta$-naphthol.

**8.** An epoxy resin composition comprising an epoxy resin and a curing agent component which contains a low molecular weight phenolic aralkyl resin having a structure represented by the formula (I) :

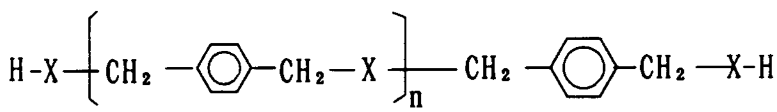

(I)

wherein X is a divalent group of

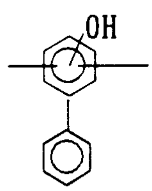

or

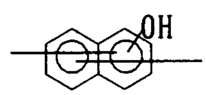

and n is an integer of from 0 to 10, and having a softening point of 100 ° C or less, in an amount of from 10 to 100 % by weight for the total weight of the curing agent component.

**9.** The epoxy resin composition of claim 8 wherein the phenolic aralkyl resin is a low molecular weight phenylphenol aralkyl resin having a structure represented by the formula (II) :

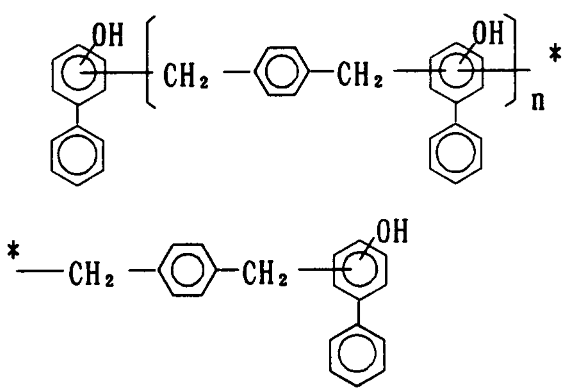

(II)

wherein n is an integer of from 0 to 10, and having a softening point of 100 ° C or less.

**10.** The epoxy resin composition of claim 8 wherein the phenolic aralkyl resin is a low molecular weight

naphthol aralkyl resin having a structure represented by the formula (III) :

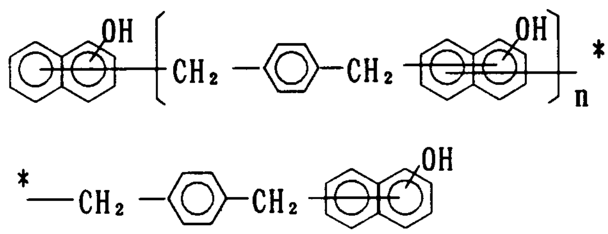

(Ⅲ)

wherein n is an integer of from 0 to 10, and having a softening point of 100 ° C or less.

**11.** The epoxy resin composition of claim 8, claim 9 or claim 10 wherein the epoxy resin is an epoxy compound obtained by reacting 2,2-bis(4-hydroxyphenyl)propane and epihalohydrin.

**12.** The epoxy resin composition of claim 8, claim 9 or claim 10 wherein the epoxy resin is an epoxy compound obtained by reacting 2,2-bis(3,5-dibromo-4-hydroxyphenyl)propane and epihalohydrin.

**13.** The epoxy resin composition of claim 8, claim 9 or claim 10 wherein the epoxy resin is an epoxy compound obtained by reacting bis(4-hydroxyphenyl)methane and epihalohydrin.

**14.** The epoxy resin composition of claim 8, claim 9 or claim 10 wherein the epoxy resin is an epoxy compound obtained by reacting phenol novolak and epihalohydrin.

**15.** The epoxy resin composition of claim 8, claim 9 or claim 10 wherein the epoxy resin is an epoxy compound obtained by reacting o-cresol novolak and epihalohydrin.

**16.** The epoxy resin composition of claim 8, claim 9 or claim 10 wherein the epoxy resin is an epoxy compound obtained by reacting 4,4'-methylenedianiline and epihalohydrin.

**17.** The epoxy resin composition of claim 8, claim 9 or claim 10 wherein the epoxy resin is a polyfunctional epoxy compound obtained by reacting a phenol aralkyl resin represented by the formula (V) :

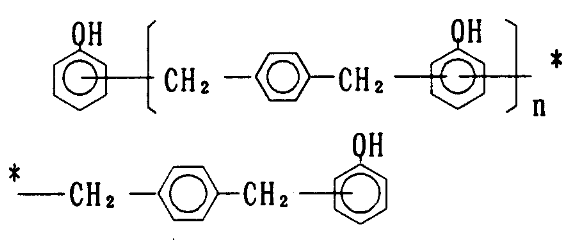

(V)

wherein n is an integer of from 0 to 100, and epihalohydrin.

**18.** The epoxy resin composition of claim 8, claim 9 or claim 10 wherein the epoxy resin is a polyfunctional epoxy compound obtained by reacting a resorcinol aralkyl resin represented by the formula (VI) :

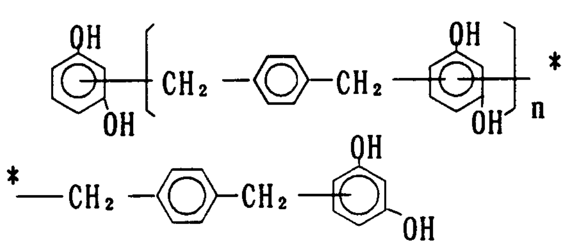

(VI)

wherein n is an integer of from 0 to 100, and epihalohydrin.

# INTERNATIONAL SEARCH REPORT

International Application No PCT/JP91/00908

**I. CLASSIFICATION OF SUBJECT MATTER** (if several classification symbols apply, indicate all) [6]

According to International Patent Classification (IPC) or to both National Classification and IPC

Int. $Cl^5$ C08G61/02, C08G59/62

**II. FIELDS SEARCHED**

Minimum Documentation Searched [7]

| Classification System | Classification Symbols |
|---|---|
| IPC | C08G61/00-61/12, C08G8/00-8/38, C08G59/00-59/72 |

Documentation Searched other than Minimum Documentation to the Extent that such Documents are Included in the Fields Searched [8]

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| Y | JP, A, 62-227988 (Hitachi Chemical Co., Ltd.), October 6, 1987 (06. 10. 87), (Family: none) | 1-4 |
| Y | JP, A, 1-95124 (Mitsui Toatsu Chemicals, Inc.), April 13, 1989 (13. 04. 89), (Family: none) | 5-7 |
| Y | JP, A, 1-93551 (Mitsui Toatsu Chemicals, Inc.), April 12, 1989 (12. 04. 89), (Family: none) | 5-7 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| September 30, 1991 (30. 09. 91) | October 14, 1991 (14. 10. 91) |
| **International Searching Authority** | **Signature of Authorized Officer** |
| Japanese Patent Office | |